# EUROPEAN PATENT APPLICATION

(11) **EP 4 517 919 A1**
(43) Date of publication of application: **05.03.2025**
(21) Application number: 23796392.1
(22) Date of filing: 25.04.2023
(51) Int. Cl.: H01M 10/42, H02J 7/02

(54) **BATTERY MANAGEMENT SYSTEM**

(30) Priority: 27.04.2022 US 202263335435 P
(71) Applicant: Nuvoton Technology Corporation Japan, Nagaokakyo City, Kyoto 617-8520 (JP)
(72) Inventor: KOBAYASHI, Hitoshi, Nagaokakyo City, Kyoto 617-8520 (JP); FUJII, Keiichi, Nagaokakyo City, Kyoto 617-8520 (JP); KAWABE, Akira, Nagaokakyo City, Kyoto 617-8520 (JP)
(74) Representative: Novagraaf International SA
(86) International application number: PCT/JP2023/016336
(87) International publication number: WO 2023/210652

(57) **Abstract**

A BMS (1) for managing a battery assembly includes: a BMU (201) that manages the battery assembly; a plurality of CMUs (101, etc.) that monitor the battery assembly; and a setting circuit (501). The BMU (201) wirelessly transmits, to the plurality of CMUs (101, etc.), a first signal including identification information of one CMU among the plurality of CMUs (101, etc.). Each of the plurality of CMUs (101, etc.) includes identification information identifying itself, receives the first signal transmitted by the BMU (201), and outputs a second signal on condition that the first signal received matches the identification information. The setting circuit (501) generates and outputs correspondence information that associates (i) position information of the one CMU, among the plurality of CMUs (101, etc.), that output the second signal with (ii) the identification information included in the first signal transmitted by the BMU (201).

## Description

### [Technical Field]

The present disclosure relates to a battery management system for managing a battery assembly.

### [Background Art]

In a battery management system that manages a battery assembly including a plurality of battery cells, it is envisioned that a management circuit performs wireless communication with a monitoring circuit to manage the battery assembly. A correspondence between identification information of battery cells and positions where the battery cells are located is used in managing the battery assembly (see, for example, Patent Literature (PTL) 1).

### [Citation List]

### [Patent Literature]

[PTL 1] U.S. Patent No. 11,011,917

### [Summary of Invention]

### [Technical Problem]

When the management circuit manages the battery assembly by performing wireless communication with the monitoring circuit, there is a problem that the unique ID of the monitoring circuit and the location of the monitoring circuit in the battery management system cannot be appropriately managed.

The present disclosure provides a battery management system and the like that can appropriately ascertain the position where the monitoring circuit is located.

### [Solution to Problem]

A battery management system according to the present disclosure is for managing a battery assembly, and includes: a management circuit that manages the battery assembly; a plurality of monitoring circuits that monitor the battery assembly; and a setting circuit. The management circuit wirelessly transmits, to the plurality of monitoring circuits, a first signal including identification information of one monitoring circuit among the plurality of monitoring circuits. Each monitoring circuit in the plurality of monitoring circuits includes identification information identifying the monitoring circuit, receives the first signal transmitted by the management circuit, and outputs a second signal on condition that the first signal received matches the identification information. The setting circuit generates and outputs correspondence information that associates (i) position information of the one monitoring circuit, among the plurality of monitoring circuits, that output the second signal with (ii) the identification information included in the first signal transmitted by the management circuit.

General or specific aspects of the present disclosure may be realized as a system, a method, an integrated circuit, a computer program, a computer-readable recording medium such as CD-ROM, or any given combination thereof.

### [Advantageous Effects of Invention]

According to the present disclosure, the battery management system can appropriately ascertain the position where the monitoring circuit is located.

### [Brief Description of Drawings]

[FIG. 1]

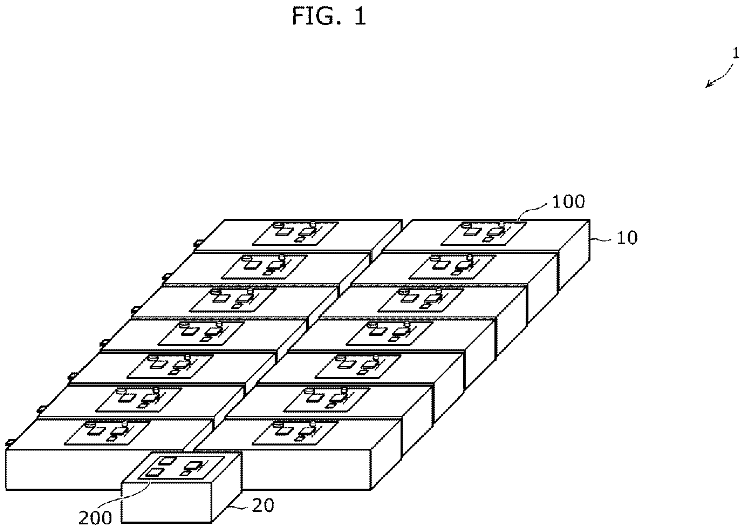

   FIG. 1 is an external view illustrating one example of a battery management system according to an embodiment of the present disclosure.
[FIG. 2]

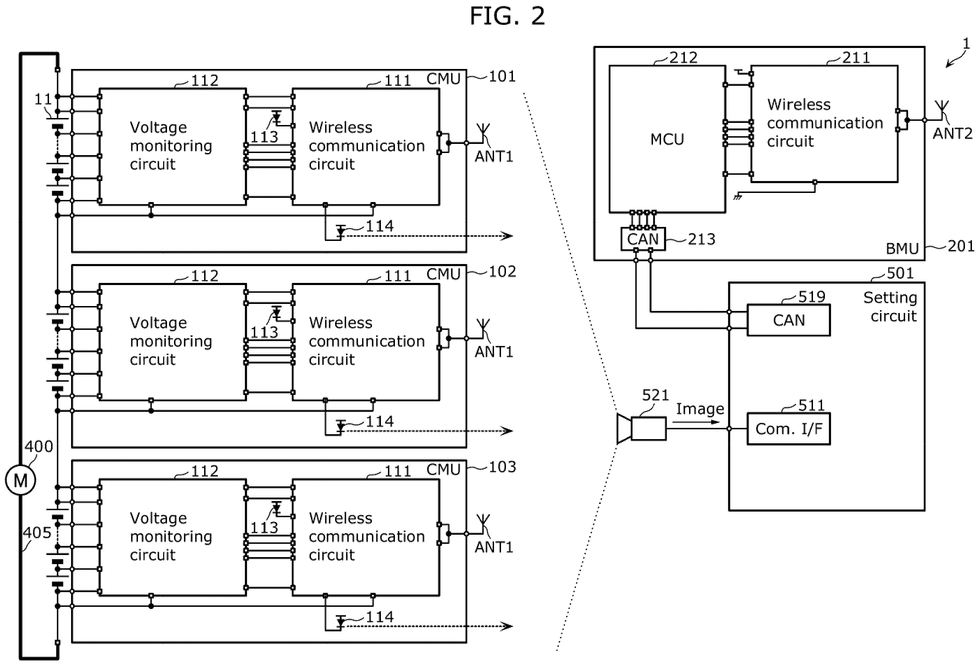

   FIG. 2 is a configuration diagram illustrating one example of a battery management system according to an embodiment of the present disclosure.
[FIG. 3]

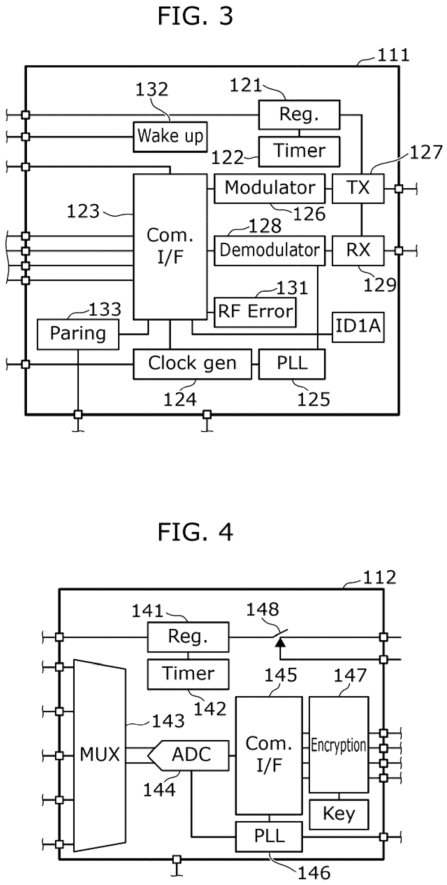

   FIG. 3 is an explanatory diagram illustrating the configuration of one example of a wireless communication circuit included in a cell monitoring circuit according to an embodiment of the present disclosure.
[FIG. 4]
   FIG. 4 is an explanatory diagram illustrating the configuration of one example of a voltage monitoring circuit included in a cell monitoring circuit according to an embodiment of the present disclosure.
[FIG. 5]

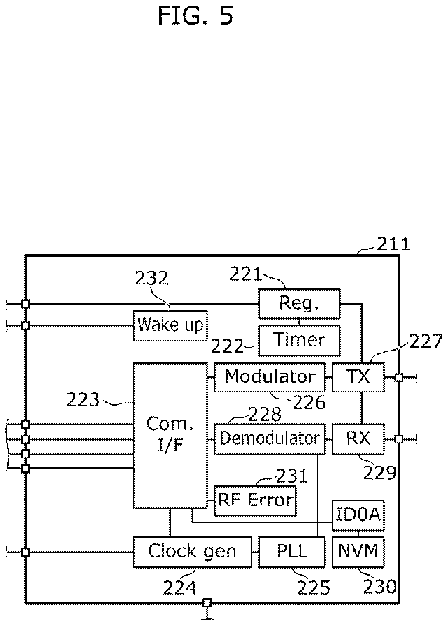

   FIG. 5 is an explanatory diagram illustrating the configuration of one example of a wireless communication circuit included in a management circuit according to an embodiment of the present disclosure.
[FIG. 6]

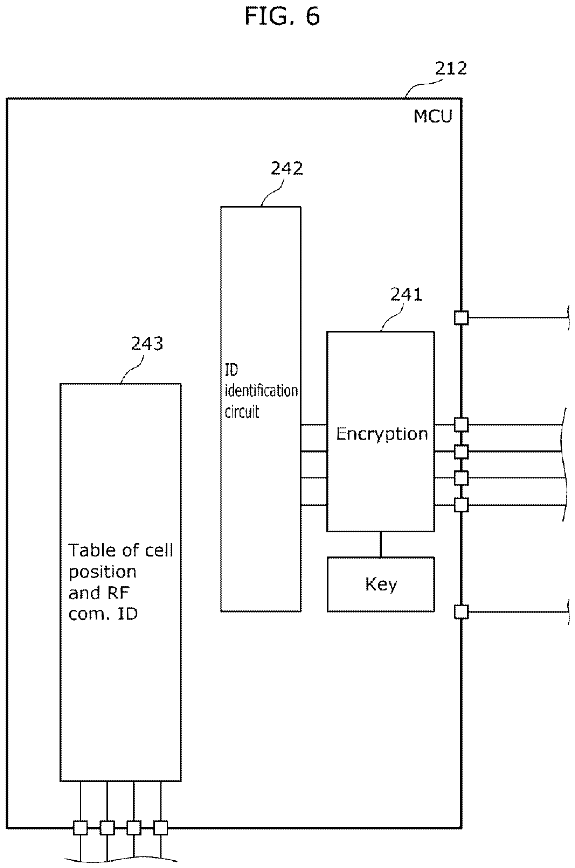

   FIG. 6 is an explanatory diagram illustrating the configuration of one example of an MCU included in a management circuit according to an embodiment of the present disclosure.
[FIG. 7]

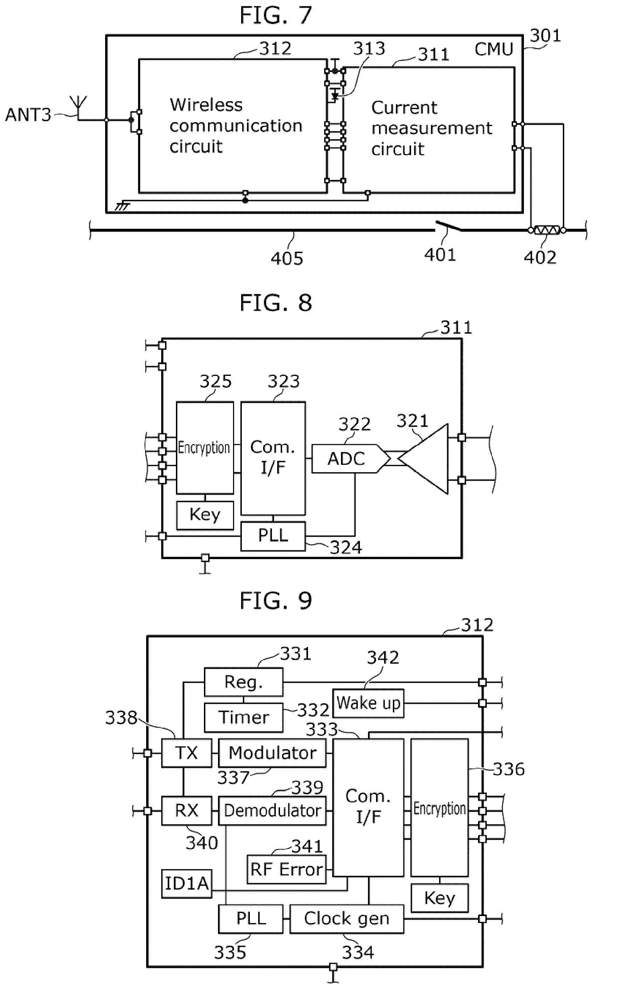

   FIG. 7 is a configuration diagram illustrating one example of a current monitoring circuit according to an embodiment of the present disclosure.
[FIG. 8]
   FIG. 8 is an explanatory diagram illustrating the configuration of one example of a current measurement circuit included in a current monitoring circuit according to an embodiment of the present disclosure.
[FIG. 9]
   FIG. 9 is an explanatory diagram illustrating the configuration of one example of a wireless communication circuit included in a current monitoring circuit according to an embodiment of the present disclosure.
[FIG. 10]

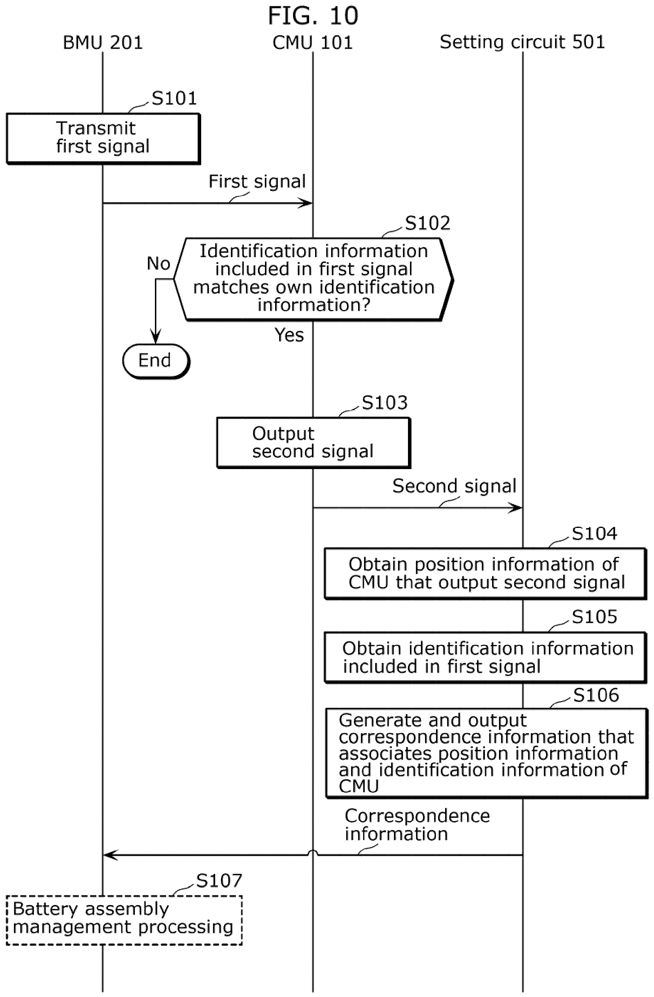

   FIG. 10 is a flowchart illustrating operations performed by a battery management system according to an embodiment of the present disclosure.
[FIG. 11]

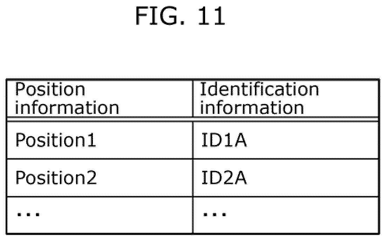

   FIG. 11 is an explanatory diagram illustrating one example of correspondence information according to an embodiment of the present disclosure.
[FIG. 12]

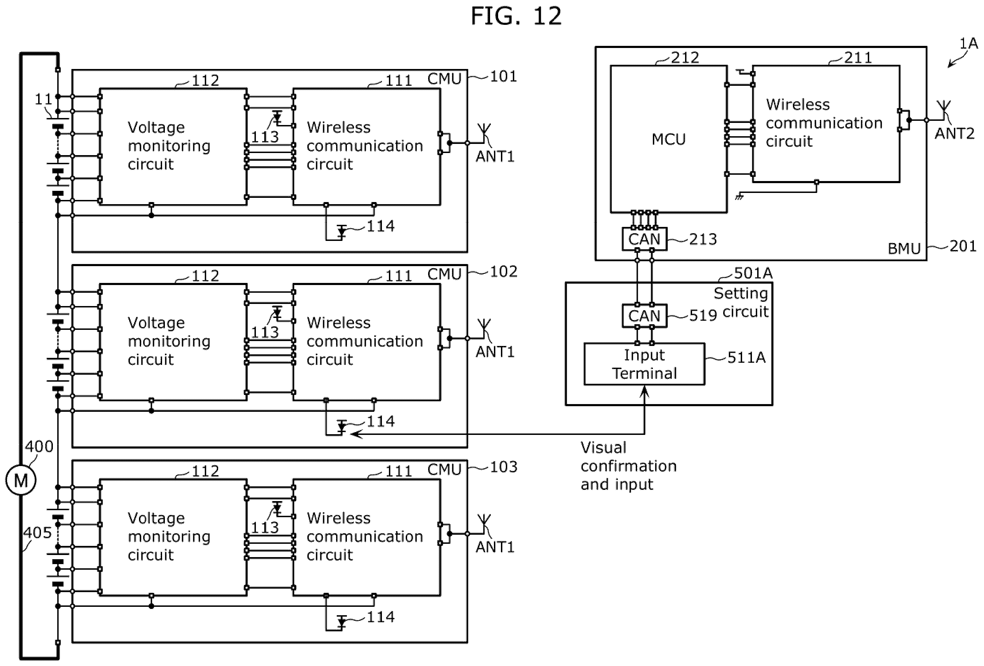

   FIG. 12 is an explanatory diagram illustrating the configuration of a battery management system according to Variation 1 of an embodiment of the present disclosure.
[FIG. 13]

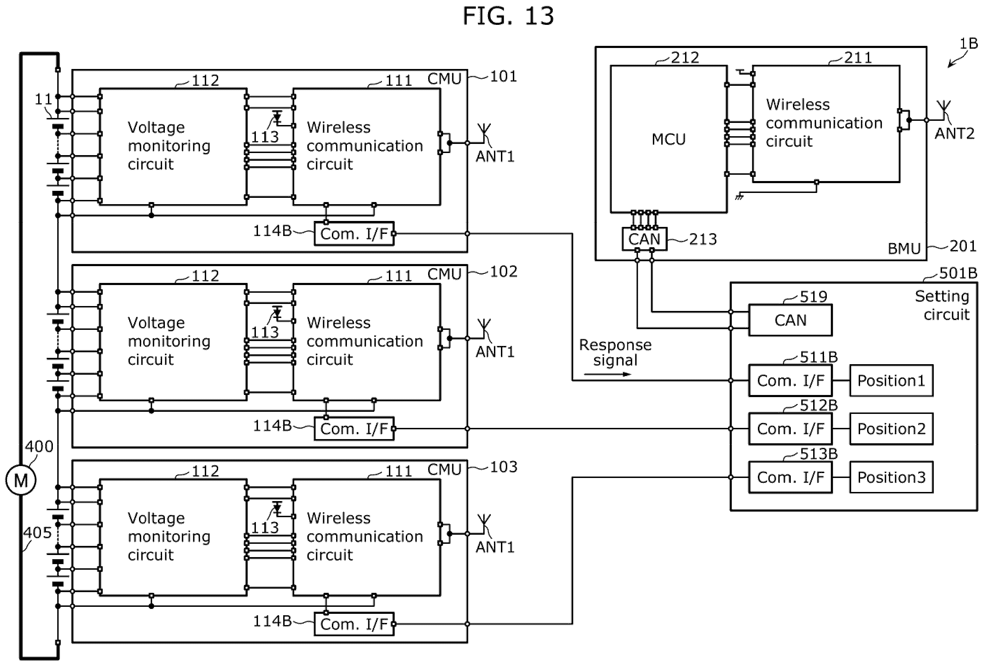

   FIG. 13 is an explanatory diagram illustrating the configuration of a battery management system according to Variation 2 of an embodiment of the present disclosure.
[FIG. 14]

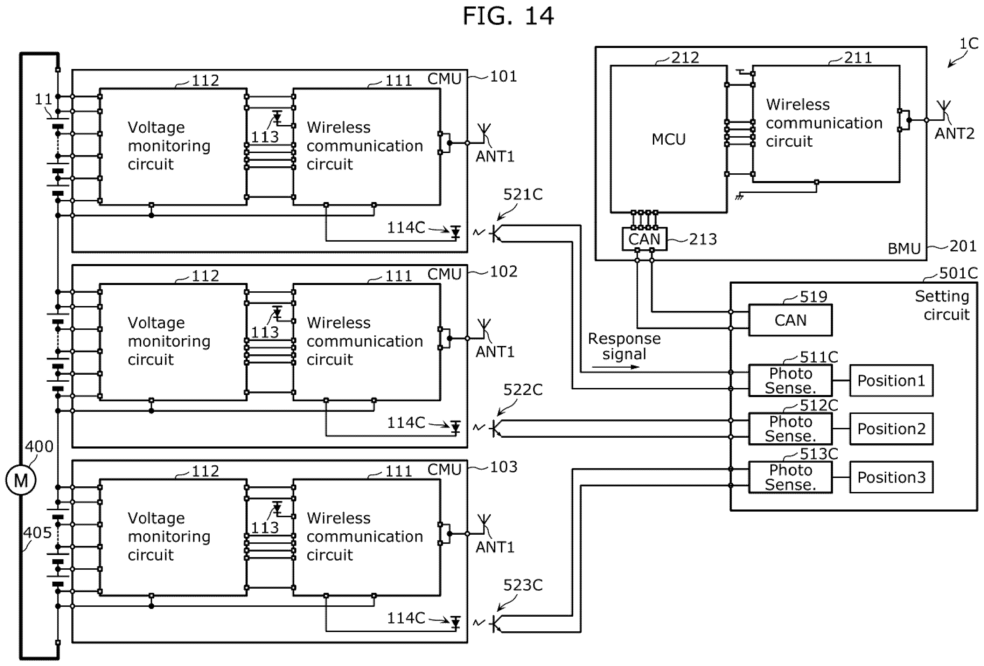

   FIG. 14 is an explanatory diagram illustrating the configuration of a battery management system according to Variation 3 of an embodiment of the present disclosure.
[FIG. 15]

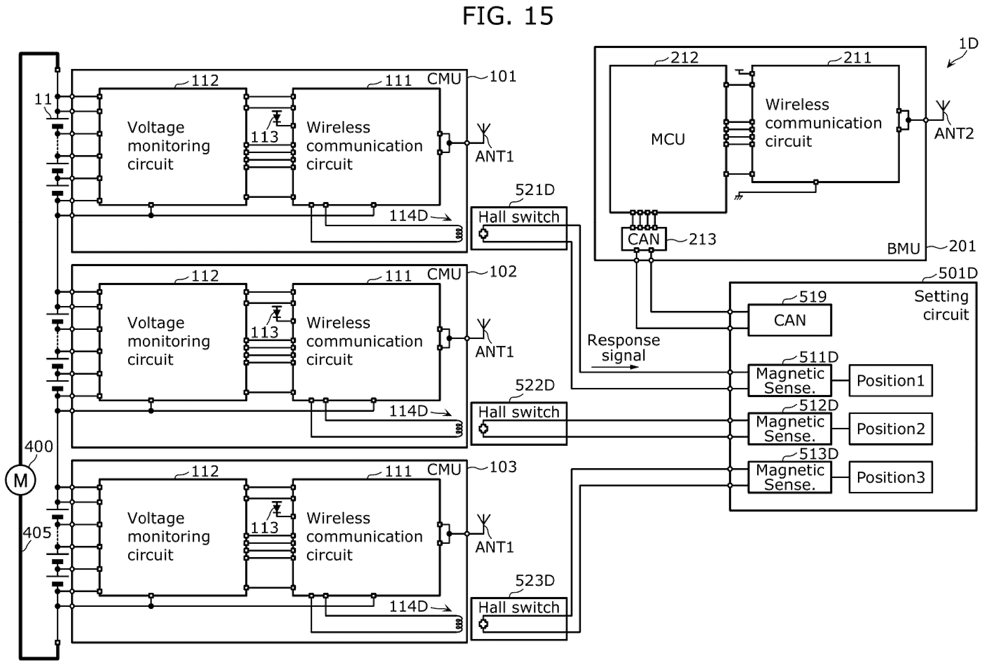

   FIG. 15 is an explanatory diagram illustrating the configuration of a battery management system according to Variation 4 of an embodiment of the present disclosure.
[FIG. 16]

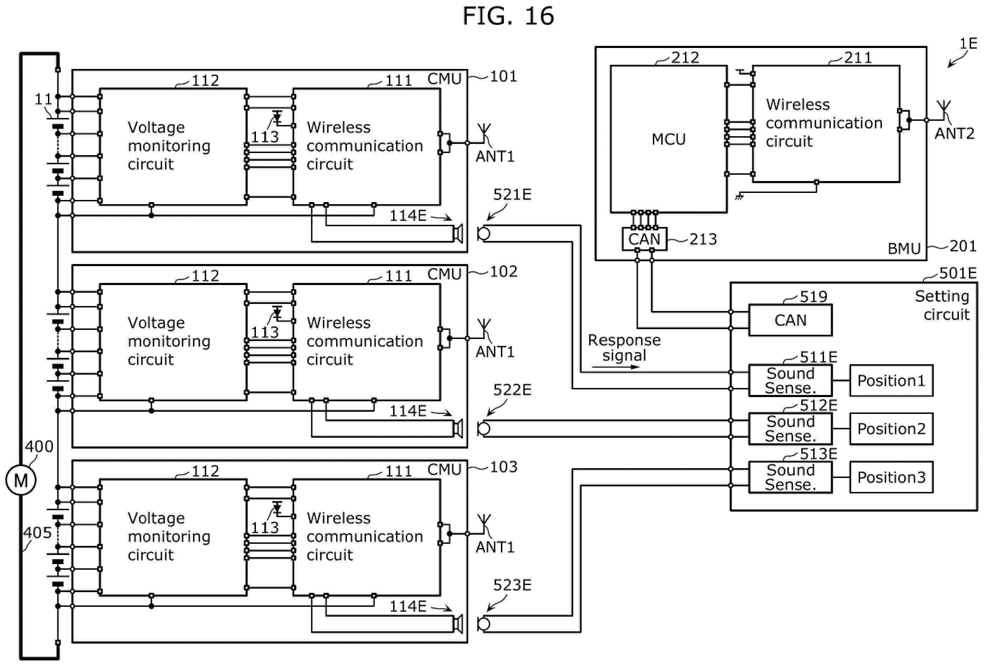

   FIG. 16 is an explanatory diagram illustrating the configuration of a battery management system according to Variation 5 of an embodiment of the present disclosure.

### [Description of Embodiments]

### Underlying Knowledge Forming the Basis of the Present Disclosure

There is a battery management system that manages a battery assembly including a plurality of battery cells. The battery assembly is used, for example, as a battery for an electric vehicle.

The battery management system includes a plurality of monitoring circuits that monitor the current or voltage of the battery cells, and a management circuit that manages the battery assembly using the plurality of monitoring circuits. The monitoring circuit includes a current monitoring circuit that monitors current flowing in a battery cell, or a cell monitoring circuit that monitors voltage of a battery cell.

The cell monitoring circuit is aware of the position where a battery cell it monitors is located. The management circuit associates the battery cell with the position of the battery cell in the overall battery assembly (in other words, the position in order in which it is connected) by knowing the unique ID of the cell monitoring circuit and the position where the cell monitoring circuit is located. The management circuit can manage individual battery cells by associating the battery cells with their positions, and can perform cell balance adjustment or determine whether individual battery cells are anomalous and the like.

The current monitoring circuit monitors the current flowing in the battery assembly and can determine whether the battery assembly is anomalous and the like.

Conventionally, in a battery management system, communication between the management circuit and the plurality of monitoring circuits is performed via wired communication. The management circuit is connected to the plurality of monitoring circuits using daisy chain communication (in other words, serial chain communication). In daisy chain communication, the plurality of monitoring circuits communicate sequentially in a bucket relay fashion. The management circuit can automatically assign unique IDs using the order of connection (also referred to as connection order) of the plurality of monitoring circuits. The unique IDs may be assigned at the start of communication, for example.

However, in a battery management system, it is conceivable that communication between the management circuit and the plurality of monitoring circuits is performed via wireless communication. In such cases, since the management circuit and the plurality of monitoring circuits do not have a wired communication connection, it is not possible to assign unique IDs to each of the plurality of monitoring circuits using the connection order as in the case of wired communication. Thus, when the management circuit performs wireless communication with the plurality of monitoring circuits, there is a problem that the management circuit cannot appropriately ascertain the unique ID of a monitoring circuit and the position where the monitoring circuit is located.

The present disclosure has an object to overcome such problems and provide a battery management system and the like in which the management circuit appropriately ascertains the position of a monitoring circuit.

Hereinafter, one or more embodiments of the present disclosure will be described in detail with reference to the drawings.

Each embodiment described below illustrates a general or specific example. The numerical values, shapes, materials, elements, the arrangement and connection of the elements, etc., shown in the following embodiments are mere examples, and therefore do not limit the scope of the present disclosure.

### [Embodiment]

In the present embodiment, a battery management system that can appropriately ascertain the position where a monitoring circuit is located will be described.

FIG. 1 is an external view illustrating one example of battery management system (hereinafter also "BMS") 1 according to an embodiment of the present disclosure. FIG. 1 illustrates the external appearance of BMS 1 during use.

BMS 1 is a system for managing a battery assembly. For example, BMS 1 manages the state of charge (SOC), state of health (SOH), and state of power (SOP) of the battery assembly. BMS 1 monitors anomalies in the battery assembly. BMS 1 includes management circuit 200 that manages the battery assembly, and a plurality of monitoring circuits 100 that monitor the battery assembly. For example, the battery assembly includes a plurality of battery packs 10 connected in series or parallel. Battery pack 10 includes one or more battery cells. When battery pack 10 includes a plurality of battery cells, the plurality of battery cells are connected in series.

Monitoring circuit 100 is, for example, disposed on each of the plurality of battery packs 10. Management circuit 200 is, for example, connected to battery assembly via junction box 20.

FIG. 2 is a configuration diagram illustrating one example of a battery management system (BMS 1) according to the present embodiment. FIG. 3 is an explanatory diagram illustrating the configuration of one example of wireless communication circuit 111 included in a cell monitoring circuit (for example, CMU 101) according to the present embodiment. FIG. 4 is an explanatory diagram illustrating the configuration of one example of voltage monitoring circuit 112 included in a cell monitoring circuit (for example, CMU 101) according to the present embodiment. FIG. 5 is an explanatory diagram illustrating the configuration of one example of wireless communication circuit 211 included in management circuit 200 according to the present embodiment. FIG. 6 is an explanatory diagram illustrating the configuration of one example of MCU 212 included in management circuit 200 according to the present embodiment. With reference to FIG. 2 through FIG. 6, the configuration of one example of a battery management system (BMS 1) will be described.

FIG. 2 illustrates a plurality of battery cells 11 included in one battery pack 10 among the plurality of battery packs 10. Cell monitoring units (CMUs) 101 and 102 as well as CMU 103 are illustrated as monitoring circuit 100, and battery management unit (BMU) 201 is illustrated as management circuit 200.

Motor 400 is illustrated as a load to which power is supplied from the battery assembly, and power line 405 (bus bar) connecting the battery assembly and motor 400 is also illustrated.

BMS 1 includes setting circuit 501. Setting circuit 501 generates and outputs correspondence information that associates position information of a monitoring circuit (specifically, CMU 101 and the like) with identification information of that monitoring circuit. The output destination of the correspondence information is, for example, BMU 201, and this case will be explained as one non-limiting example. Associating the position information of a monitoring circuit with the identification information of that monitoring circuit is also referred to as pairing. Note that setting circuit 501 is assumed to be included in BMS 1 when generating the correspondence information, but need not be included during use of BMS 1.

Note that a shunt resistor for measuring current flowing in power line 405 may be connected to power line 405. In such cases, BMS 1 further includes a current monitoring circuit (for example, CMU 301 to be described later) that measures the current flowing in power line 405 using the shunt resistor. A current monitoring circuit is one example of a monitoring circuit.

CMU 101 is one example of a cell monitoring circuit that monitors one or more battery cells included in the battery assembly. For example, CMU 101 monitors the voltage of each of a plurality of battery cells 11.

Each of CMUs 102 and 103 is, like CMU 101, one example of a cell monitoring circuit that monitors one or more battery cells included in the battery assembly.

CMU 101 includes wireless communication circuit 111 and communication antenna ANT1 for communicating with BMU 201. CMU 101 includes voltage monitoring circuit 112 that monitors the voltage of each of the plurality of battery cells 11. For example, wireless communication circuit 111 and voltage monitoring circuit 112 are each implemented by different integrated circuits (ICs). Note that wireless communication circuit 111 and voltage monitoring circuit 112 may be implemented by a single IC.

As illustrated in FIG. 3, wireless communication circuit 111 includes voltage conversion circuit (Reg.) 121, timer circuit (Timer) 122, communications interface (Com. I/F) 123, clock generation circuit (Clock gen) 124, phase-locked loop (PLL) 125, modulation circuit (Modulator) 126, transmission circuit (Tx) 127, demodulation circuit (Demodulator) 128, reception circuit (Rx) 129, communication error determination circuit (RF Error) 131, wake-up circuit (Wake up) 132, and pairing circuit (Paring) 133.

Voltage conversion circuit 121 is a circuit that converts the voltage input from voltage monitoring circuit 112 to a voltage for operating wireless communication circuit 111 and outputs the converted voltage.

Timer circuit 122 is a circuit that counts time. For example, timer circuit 122 is used to operate wireless communication circuit 111 intermittently.

Communications interface 123 is an interface for performing communication between wireless communication circuit 111 and voltage monitoring circuit 112. The identification information "ID1A" is associated with communications interface 123. Note that the identification information of communications interface 123 may be stored in any memory included in wireless communication circuit 111. Note that when wireless communication circuit 111 and voltage monitoring circuit 112 are implemented by a single IC, communications interface 123 may be omitted.

Clock generation circuit 124 is a circuit for generating a clock in CMU 101.

Phase-locked loop 125 is a circuit that adjusts the phase of a local signal to match the phase of a received signal.

Modulation circuit 126 is a circuit that modulates signals to be transmitted to BMU 201.

Transmission circuit 127 is a circuit for transmitting signals to BMU 201. Transmission circuit 127 transmits signals to BMU 201 via communication antenna ANT1.

Demodulation circuit 128 is a circuit that demodulates signals received from BMU 201.

Reception circuit 129 is a circuit for receiving signals from BMU 201. Reception circuit 129 receives signals from BMU 201 via communication antenna ANT1.

Communication error determination circuit 131 is a circuit that determines whether an anomaly has occurred in the communication between CMU 101 and BMU 201.

Wake-up circuit 132 is a circuit for activating wireless communication circuit 111.

Pairing circuit 133 is a circuit for outputting a signal (also referred to as a second signal) for pairing registration. Pairing circuit 133 outputs the second signal when it receives a signal (also referred to as a first signal) from BMU 201 that includes identification information identical to its own identification information. Pairing circuit 133 is connected to, for example, LED 114, and outputs the second signal by causing LED 114 to emit light.

CMU 102 and 103 each have a configuration similar to that of CMU 101. However, identification information "ID2A" is associated with communications interface 123 of CMU 102, and identification information "ID3A" is associated with communications interface 123 of CMU 103.

As illustrated in FIG. 2, CMU 101 may include LED 113, for example. For example, LED 113 emits light when wireless communication circuit 111 satisfies a specific condition.

As illustrated in FIG. 4, voltage monitoring circuit 112 includes voltage conversion circuit (Reg.) 141, timer circuit (Timer) 142, multiplexer (MUX) 143, AD converter (ADC) 144, communications interface (Com. I/F) 145, phase-locked loop (PLL) 146, encryption circuit (Encryption) 147, and switch 148.

Voltage conversion circuit 141 is a circuit that converts the voltage input from the battery assembly to a voltage for operating voltage monitoring circuit 112 and outputs the converted voltage.

Timer circuit 142 is a circuit that counts time. For example, timer circuit 142 is a circuit for operating wireless communication circuit 111 intermittently. Although CMU 101 includes timer circuits 122 and 142 in wireless communication circuit 111 and voltage monitoring circuit 112, respectively, CMU 101 need not include both timer circuits 122 and 142. Stated differently, wireless communication circuit 111 need not include timer circuit 122, or voltage monitoring circuit 112 need not include timer circuit 142.

Multiplexer 143 selects one battery cell 11 from among the plurality of battery cells 11 and outputs the terminal voltage of the selected battery cell 11. Stated differently, multiplexer 143 can output the voltage of each of the plurality of battery cells 11.

AD converter 144 converts the voltage value (analog value) of battery cell 11 selected by multiplexer 143 into a digital value.

Communications interface 145 is an interface for performing communication between wireless communication circuit 111 and voltage monitoring circuit 112. Note that when wireless communication circuit 111 and voltage monitoring circuit 112 are implemented by a single IC, communications interface 145 may be omitted.

Phase-locked loop 146 is a circuit that adjusts the phase of a local signal to match the phase of a received signal.

Encryption circuit 147 is a circuit that encrypts and decrypts signals. For example, encryption circuit 147 encrypts signals to be transmitted to wireless communication circuit 111 and ultimately to BMU 201, using an encryption key (Key).

Switch 148 is a switch that toggles on and off the power supply to wireless communication circuit 111, and is, for example, a transistor or the like. Switch 148 is controlled by a control signal from wake-up circuit 132. Wake-up circuit 132 can control the activation of wireless communication circuit 111 by controlling switch 148 to control the power supply to wireless communication circuit 111.

CMU 101 detects the voltage value of each of the plurality of battery cells 11 using voltage monitoring circuit 112, and transmits the detected voltage values to BMU 201 using wireless communication circuit 111.

As illustrated in FIG. 2, BMU 201 includes wireless communication circuit 211 and communication antenna ANT2 for communicating with CMU 101, as well as control area network (CAN) interface (CAN) 213 for communicating with setting circuit 501. BMU 201 also includes a micro controller unit (MCU) 212 for managing the battery assembly. Note that wireless communication circuit 211, MCU 212, and CAN interface 213 may be implemented by a single IC (for example, a single MCU).

As illustrated in FIG. 5, wireless communication circuit 211 includes voltage conversion circuit (Reg.) 221, timer circuit (Timer) 222, communications interface (Com. I/F) 223, clock generation circuit (Clock gen) 224, phase-locked loop (PLL) 225, modulation circuit (Modulator) 226, transmission circuit (Tx) 227, demodulation circuit (Demodulator) 228, reception circuit (Rx) 229, non-volatile memory (NVM) 230, communication error determination circuit (RF Error) 231, and wake-up circuit (Wake up) 232. FIG. 5 illustrates "ID0A" as the identification information of wireless communication circuit 211.

Voltage conversion circuit 221 is a circuit that converts the voltage input from any power source to a voltage for operating wireless communication circuit 211 and outputs the converted voltage.

Timer circuit 222 is a circuit that counts time.

Communications interface 223 is an interface for performing communication between wireless communication circuit 211 and MCU 212. Note that when wireless communication circuit 211 and MCU 212 are implemented by a single IC, communications interface 223 may be omitted.

Clock generation circuit 224 is a circuit for generating a clock in BMU 201.

Phase-locked loop 225 is a circuit that adjusts the phase of a local signal to match the phase of a received signal.

Modulation circuit 226 is a circuit that modulates signals to be transmitted to CMU 101.

Transmission circuit 227 is a circuit for transmitting signals to CMU 101. Transmission circuit 227 transmits signals to CMU 101 via communication antenna ANT2.

Demodulation circuit 228 is a circuit that demodulates signals received from CMU 101.

Reception circuit 229 is a circuit for receiving signals from CMU 101. Reception circuit 229 receives signals from CMU 101 via communication antenna ANT2.

Non-volatile memory 230 stores identification information of wireless communication circuit 211. For example, non-volatile memory 230 stores the identification information "ID0A". Note that FIG. 5 illustrates non-volatile memory 230, but the identification information may be stored in any memory included in wireless communication circuit 211.

Communication error determination circuit 231 is a circuit that determines whether an anomaly has occurred in the communication between CMU 101 and BMU 201.

Wake-up circuit 232 is a circuit for activating MCU 212.

As illustrated in FIG. 6, MCU 212 includes encryption circuit (Encryption) 241 and identification circuit (ID identification circuit) 242. MCU 212 also stores table (table of cell position and RF com. ID) 243 showing the correspondence between the positions of each of the plurality of battery cells 11 in battery pack 10 and identification information such as the wireless communication circuit of the CMU of each battery pack 10.

Encryption circuit 241 is a circuit that encrypts and decrypts signals. For example, encryption circuit 241 decrypts signals (for example, voltage values of battery cell 11) transmitted from CMU 101, using an encryption key (Key).

Identification circuit 242 uses table 243 to identify which position of battery cell 11 in which battery pack 10 the voltage value of battery cell 11 included in the signal transmitted from CMU 101 corresponds to.

CAN interface 213 is an interface for performing communication between setting circuit 501 and BMU 201 via a CAN. The CAN may be a CAN included in the vehicle in which the battery assembly is mounted.

BMU 201 may be connected to a controller area network (CAN) and may be configured to communicate with other circuits via the CAN.

BMS 1 includes current monitoring unit (CMU) 301 as monitoring circuit 100. When BMS 1 includes CMU 301, BMS 1 may further include relay 401. An example of a configuration in which BMS 1 includes CMU 301 will be given.

FIG. 7 is a configuration diagram illustrating CMU 301 as one example of a current monitoring circuit according to the present embodiment. In addition to CMU 301, FIG. 7 also illustrates relay 401, shunt resistor 402, and power line 405.

As illustrated in FIG. 7, CMU 301 includes current measurement circuit 311 that measures current flowing in power line 405. CMU 301 includes wireless communication circuit 312 and communication antenna ANT3 for communicating with BMU 201. For example, current measurement circuit 311 and wireless communication circuit 312 are each implemented by different integrated circuits (ICs). Note that current measurement circuit 311 and wireless communication circuit 312 may be implemented by a single IC.

Relay 401 is a switch for interrupting current flowing in power line 405. For example, relay 401 is turned off to interrupt current flowing in power line 405 when the current monitored by CMU 301 using shunt resistor 402 is determined to be anomalous. For example, the relay is turned off to interrupt current flowing in power line 405 when the voltage monitored by CMU 101 or the like is determined to be anomalous.

FIG. 8 is an explanatory diagram illustrating the configuration of one example of the current measurement circuit included in the current monitoring circuit according to the present embodiment.

As illustrated in FIG. 8, current measurement circuit 311 includes amplification circuit 321, AD converter (ADC) 322, communications interface (Com. I/F) 323, phase-locked loop (PLL) 324, and encryption circuit (Encryption) 325.

Amplification circuit 321 amplifies the voltage generated across shunt resistor 402. Amplification circuit 321 is provided because the resistance value of shunt resistor 402 is extremely small, and the voltage generated across shunt resistor 402 is also small.

AD converter 322 converts the voltage value (analog value) generated across shunt resistor 402 into a digital value.

Communications interface 323 is an interface for performing communication between wireless communication circuit 312 and current measurement circuit 311. Note that when wireless communication circuit 312 and current measurement circuit 311 are implemented by a single IC, communications interface 323 may be omitted.

Phase-locked loop 324 is a circuit that adjusts the phase of a local signal to match the phase of a received signal.

Encryption circuit 325 is a circuit that encrypts and decrypts signals. For example, encryption circuit 325 encrypts signals to be transmitted to wireless communication circuit 312 and ultimately to BMU 201, using an encryption key (Key).

FIG. 9 is an explanatory diagram illustrating the configuration of one example of the wireless communication circuit included in the current monitoring circuit according to the present embodiment.

As illustrated in FIG. 9, wireless communication circuit 312 includes voltage conversion circuit (Reg.) 331, timer circuit (Timer) 332, communications interface (Com. I/F) 333, clock generation circuit (Clock gen) 334, phase-locked loop (PLL) 335, encryption circuit (Encryption) 336, modulation circuit (Modulator) 337, transmission circuit (Tx) 338, demodulation circuit (Demodulator) 339, reception circuit (Rx) 340, communication error determination circuit (RF Error) 341, and wake-up circuit (Wake up) 342. FIG. 9 illustrates "ID1A" as the identification information of wireless communication circuit 312.

Voltage conversion circuit 331 is a circuit that converts the voltage input from any power source to a voltage for operating wireless communication circuit 312 and outputs the converted voltage.

Timer circuit 332 is a circuit that counts time.

Communications interface 333 is an interface for performing communication between wireless communication circuit 312 and current measurement circuit 311. Note that when wireless communication circuit 312 and current measurement circuit 311 are implemented by a single IC, communications interface 333 may be omitted.

Clock generation circuit 334 is a circuit for generating a clock in CMU 301.

Phase-locked loop 335 is a circuit that adjusts the phase of a local signal to match the phase of a received signal.

Encryption circuit 336 is a circuit that encrypts and decrypts signals. For example, encryption circuit 336 encrypts signals to be transmitted to BMU 201, using an encryption key (Key). Although CMU 301 includes encryption circuits 325 and 336 in current measurement circuit 311 and wireless communication circuit 312, respectively, CMU 301 need not include both encryption circuits 325 and 336. Stated differently, wireless communication circuit 312 need not include encryption circuit 336, or current measurement circuit 311 need not include encryption circuit 325.

Modulation circuit 337 is a circuit that modulates signals to be transmitted to BMU 201.

Transmission circuit 338 is a circuit for transmitting signals to BMU 201. Transmission circuit 338 transmits signals to BMU 201 via communication antenna ANT3.

Demodulation circuit 339 is a circuit that demodulates signals received from BMU 201.

Reception circuit 340 is a circuit for receiving signals from BMU 201. Reception circuit 340 receives signals from BMU 201 via communication antenna ANT3.

Communication error determination circuit 341 is a circuit that determines whether an anomaly has occurred in the communication between CMU 301 and BMU 201.

Wake-up circuit 342 is a circuit for activating current measurement circuit 311.

As illustrated in FIG. 7, CMU 301 may include LED 313, for example. For example, LED 313 emits light when wireless communication circuit 312 satisfies a specific condition.

As illustrated in FIG. 2, setting circuit 501 includes communications interface (Com. I/F) 511 for communicating with camera 521, and CAN interface (CAN) 519 for communicating with BMU 201.

Communications interface 511 receives, from camera 521, image data (also referred to simply as images) generated via image capture by camera 521. Camera 521 is disposed at a predetermined position from which it is capable of capturing images of a plurality of monitoring circuits. Stated differently, camera 521 is disposed at a predetermined position where it can receive light emitted by LEDs (specifically, LED 114 of CMU 101 and the like) included in the plurality of monitoring circuits.

CAN interface 519 is an interface for performing communication between setting circuit 501 and BMU 201 via a CAN.

Setting circuit 501 generates the correspondence information through information processing performed by a processor (for example, a central processing unit (CPU)) (not illustrated in the drawings) using memory.

Operations performed by BMS 1 having the above circuit configuration will be explained.

FIG. 10 is a flowchart illustrating operations performed by BMS 1 according to the present embodiment. FIG. 11 is an explanatory diagram illustrating one example of correspondence information according to the present embodiment.

Initially, table 243 of MCU 212 does not store the correspondence between the positions of each of the plurality of battery cells 11 in battery pack 10 and identification information of, for example, the wireless communication circuit of the CMU of each battery pack 10. Here, BMS 1 first generates this correspondence and stores it in table 243 of MCU 212.

BMU 201 wirelessly transmits a signal (also referred to as a first signal) including identification information of one monitoring circuit among the plurality of monitoring circuits (i.e., CMU 101 to 103) to the plurality of monitoring circuits (step S101). As one example, BMU 201 transmits a first signal including the identification information "ID1A". The identification information is information that can uniquely identify a monitoring circuit, and may be numerical information that can be expressed in several bytes (for example, approximately 1 to 6 bytes).

Each of the plurality of monitoring circuits receives the first signal transmitted by BMU 201. Each of the plurality of monitoring circuits determines whether the received first signal matches its own identification information (step S102), and outputs a second signal when the identification information is determined to match (step S103).

For example, when the first signal includes the identification information "ID1A", CMU 101 determines that the received first signal matches its own identification information and outputs the second signal. However, CMU 102 and 103 do not output the second signal when they determine that the received first signal does not match their own identification information.

When outputting the second signal, in one example, the monitoring circuit outputs the second signal as light. More specifically, the monitoring circuit outputs the second signal by causing the connected LED to emit light.

Setting circuit 501 generates and outputs correspondence information for the identification information included in the first signal transmitted by BMU 201. The correspondence information generated by setting circuit 501 is correspondence information that associates the position information of one monitoring circuit, among the plurality of monitoring circuits, that output the second signal with the identification information included in the first signal received by the one monitoring circuit. For example, the output destination of the correspondence information from setting circuit 501 is, but is not limited to, BMU 201.

More specifically, when generating and outputting the correspondence information, setting circuit 501 obtains the position information of one monitoring circuit, among the plurality of monitoring circuits, that output the second signal (step S104).

When the monitoring circuit outputs the second signal as light, setting circuit 501 generates and outputs correspondence information by obtaining an image showing a plurality of monitoring circuits including the one monitoring circuit outputting light, and identifying the position information of the one monitoring circuit by performing image processing on the obtained image. For example, a plurality of monitoring circuits are captured in the image, and the plurality of monitoring circuits include the one monitoring circuit that is outputting light. Setting circuit 501 can identify the position information of the one monitoring circuit outputting light among the plurality of monitoring circuits by calculating the position of the one monitoring circuit through image processing.

Next, setting circuit 501 obtains the identification information included in the first signal transmitted by BMU 201 (step S105). Setting circuit 501 generates and outputs correspondence information that associates the obtained position information and identification information (step S106). More specifically, setting circuit 501 transmits the correspondence information to BMU 201 via CAN interface 519 and the CAN. The transmitted correspondence information is assumed to be stored in table 243 of MCU 212.

FIG. 11 illustrates an example of the correspondence information generated by setting circuit 501.

The correspondence information is information that, for each of the plurality of monitoring circuits, associates position information and identification information of the monitoring circuit. For example, in the correspondence information illustrated in FIG. 11, identification information "ID1A" is associated with position information "Position1". This indicates that a monitoring circuit with the identification information "ID1A" is placed at the position "Position1" in BMS 1. The association between the position information "Position1" and the identification information "ID1A" is, for example, generated by setting circuit 501 based on the CMU placed at the position indicated by the position information "Position1" outputting light when BMU 201 transmitted the identification information "ID1A".

BMU 201, which received the correspondence information transmitted in step S106, can execute management processing of the battery assembly by performing communication for managing the battery assembly with the monitoring device using the received correspondence information (step S107).

When BMU 201 obtains the states (for example, voltage values) of the plurality of battery cells 11 monitored by, as one example, the CMU assigned with the identification information "ID2A" (that is, CMU 102), it broadcasts a request signal by wireless communication to cause the CMU assigned with the identification information "ID2A" to transmit the monitoring results to BMU 201.

CMU 101 receives the request signal, and because the identification information included in the request signal does not match its own identification information "ID1A", it determines that the request signal is not addressed to itself, and does not perform any processing in response to the received request signal. The same applies to CMU 103.

CMU 102 receives the request signal, and because the identification information included in the request signal matches its own identification information "ID2A", it determines that the request signal is addressed to itself, and performs processing to transmit the monitoring results of the plurality of battery cells 11 that it monitors to BMU 201. More specifically, CMU 102 obtains the voltage values of each of the plurality of battery cells 11 using multiplexer 143, and transmits to BMU 201 each voltage value, information indicating which position of battery cell 11 among the plurality of battery cells 11 each voltage value corresponds to, and the identification information of CMU 102. For example, depending on which battery cell 11 multiplexer 143 selected when obtaining the voltage value, it is possible to identify which position of battery cell 11 among the plurality of battery cells 11 the voltage value corresponds to.

BMU 201 receives, as a response to the request signal, information indicating the voltage values of the plurality of battery cells 11 monitored by CMU 102 from CMU 102. BMU 201 can identify which position of battery cell 11 in which battery pack 10 each of the voltage values of the plurality of battery cells 11 corresponds to by matching this information with table 243.

When the monitoring device is CMU 301, CMU 301 receives the request signal and performs processing to transmit the monitoring results of the battery assembly that it monitors to BMU 201. More specifically, CMU 301 measures the current flowing in the battery assembly and transmits it to BMU 201. With this, BMU 201 can obtain the current flowing in the battery assembly.

### Variation 1 of Embodiment

In the present variation, another example of the configuration of the battery management system will be given.

FIG. 12 is an explanatory diagram illustrating the configuration of BMS 1A, which is a battery management system according to the present variation. BMS 1A generates correspondence information using visual confirmation by a user.

CMU 101 and the like according to the present variation are the same as CMU 101 and the like according to the embodiment.

BMU 201 according to the present variation is the same as BMU 201 according to the embodiment.

Setting circuit 501A includes input terminal 511A.

Input terminal 511A accepts input from a user regarding position information indicating the position of the monitoring circuit that is outputting light. It is assumed that the user visually confirms the second signal output by CMU 101 or the like through light emission, and inputs position information (for example, Position1, Position2, etc.) indicating the position of CMU 101 or the like that is emitting light.

When obtaining the position information of the CMU in step S104 (see FIG. 10), setting circuit 501A obtains the position information of CMU 101 or the like input to input terminal 511A. Setting circuit 501A generates and outputs correspondence information by associating the obtained position information and identification information (step S106).

In this way, setting circuit 501A can accept an input of position information of the monitoring circuit that output light from the user, and generate and output correspondence information by associating the input position information with identification information.

### Variation 2 of Embodiment

In the present variation, another example of the configuration of the battery management system will be given.

FIG. 13 is an explanatory diagram illustrating the configuration of BMS 1B, which is a battery management system according to the present variation. BMS 1B generates correspondence information using wired communication.

CMU 101 and the like according to the present variation include communications interface (Com. I/F) 114B. The other configurations are the same as CMU 101 and the like according to the embodiment.

Pairing circuit 133 included in CMU 101 and the like is connected to communications interface 114B. Pairing circuit 133 outputs the second signal via communications interface 114B when it receives a signal (the first signal) from BMU 201 that includes identification information identical to its own identification information.

BMU 201 according to the present variation is the same as BMU 201 according to the embodiment.

Setting circuit 501B includes communications interfaces (Com. I/F) 511B, 512B, and 513B. Each of communications interfaces (Com. I/F) 511B and the like may correspond to a communication port.

Communications interface 511B is connected to communications interface 114B of CMU 101 via a communication line, and receives the second signal output by communications interface 114B. The position information "Position1" is associated with communications interface 511B of the connected monitoring circuit.

Communications interface 512B is connected to communications interface 114B of CMU 102 via a communication line, and receives the second signal output by communications interface 114B. The position information "Position2" is associated with communications interface 512B of the connected monitoring circuit.

Communications interface 513B is connected to communications interface 114B of CMU 103 via a communication line, and receives the second signal output by communications interface 114B. The position information "Position3" is associated with communications interface 513B of the connected monitoring circuit.

When any of communications interfaces 511B, 512B, and 513B receives the second signal, setting circuit 501B can obtain position information indicating the position of the monitoring circuit outputting the second signal by obtaining the position information associated with the communications interface that received the second signal (step S104 (see FIG. 10)). Setting circuit 501B generates and outputs correspondence information by associating the obtained position information and identification information (step S106).

In this way, setting circuit 501B can generate and output correspondence information using the position information associated with one communications interface, among the plurality of communications interfaces, that received the output second signal.

### Variation 3 of Embodiment

In the present variation, another example of the configuration of the battery management system will be given.

FIG. 14 is an explanatory diagram illustrating the configuration of BMS 1C, which is a battery management system according to the present variation. BMS 1C generates correspondence information using wired communication including contactless communication using light.

Each of CMU 101 and the like according to the present variation includes LED 114C. The other configurations are the same as CMU 101 and the like according to the embodiment.

Pairing circuit 133 included in CMU 101 and the like is connected to LED 114C. Pairing circuit 133 outputs the second signal by causing LED 114C to emit light when it receives a signal (the first signal) from BMU 201 that includes identification information identical to its own identification information.

BMU 201 according to the present variation is the same as BMU 201 according to the embodiment.

Setting circuit 501C includes photosensor circuits (Photo Sense.) 511C, 512C, and 513C.

Photosensor circuit 511C is connected to photosensor element 521C. Photosensor element 521C is positioned at a location where it can receive light output by LED 114C of CMU 101 (for example, a position in proximity to LED 114C, specifically within approximately several centimeters from LED 114C; similarly hereinafter), and receives the second signal by receiving the light output by LED 114C. The position information "Position1" is associated with photosensor circuit 511C of the connected monitoring circuit. Photosensor circuit 511C can also be said to be a communications interface that performs contactless communication with CMU 101 using light, by means of elements (specific examples include LED 114C and photosensor element 521C) that perform contactless communication using light. LED 114C and photosensor element 521C can also be said to constitute a photocoupler.

Photosensor circuit 512C is connected to photosensor element 522C. Photosensor element 522C is positioned at a location where it can receive light output by LED 114C of CMU 102, and receives the second signal by receiving the light output by LED 114C. The position information "Position2" is associated with photosensor circuit 512C of the connected monitoring circuit. Other features of photosensor circuit 512C are similar to those of photosensor circuit 511C.

Photosensor circuit 513C is connected to photosensor element 523C. Photosensor element 523C is positioned at a location where it can receive light output by LED 114C of CMU 103, and receives the second signal by receiving the light output by LED 114C. The position information "Position3" is associated with photosensor circuit 513C of the connected monitoring circuit. Other features of photosensor circuit 513C are similar to those of photosensor circuit 511C.

When any of photosensor circuits 511C, 512C, and 513C receives the second signal, setting circuit 501C can obtain position information indicating the position of the monitoring circuit outputting the second signal by obtaining the position information associated with the communications interface that received the second signal (step S104 (see FIG. 10)). Setting circuit 501C generates and outputs correspondence information by associating the obtained position information and identification information (step S106).

In this way, setting circuit 501C can generate and output correspondence information using a communication line that includes elements that perform contactless communication using light.

### Variation 4 of Embodiment

In the present variation, another example of the configuration of the battery management system will be given.

FIG. 15 is an explanatory diagram illustrating the configuration of BMS 1D, which is a battery management system according to the present variation. BMS 1D generates and outputs correspondence information using wired communication including contactless communication using a magnetic field.

Each of CMU 101 and the like according to present variation includes coil 114D. The other configurations are the same as CMU 101 and the like according to the embodiment.

Pairing circuit 133 included in CMU 101 and the like is connected to coil 114D. Pairing circuit 133 outputs the second signal by causing coil 114D to generate a magnetic field when it receives a signal (the first signal) from BMU 201 that includes identification information identical to its own identification information.

BMU 201 according to the present variation is the same as BMU 201 according to the embodiment.

Setting circuit 501D includes magnetic sensor circuits (Magnetic Sense.) 511D, 512D, and 513D.

Magnetic sensor circuit 511D is connected to Hall switch 521D. Hall switch 521D is positioned at a location where it can detect the magnetic field generated by coil 114D of CMU 101 (for example, a position in proximity to coil 114D, specifically within approximately several centimeters from coil 114D), and receives the second signal by detecting the magnetic field generated by coil 114D. The position information "Position1" is associated with magnetic sensor circuit 511D of the connected monitoring circuit. Magnetic sensor circuit 511D can also be said to be a communications interface that performs contactless communication with CMU 101 using a magnetic field, by means of elements (specific examples include coil 114D and Hall switch 521D) that perform contactless communication using a magnetic field.

Magnetic sensor circuit 512D is connected to Hall switch 522D. Hall switch 522D is positioned at a location where it can detect the magnetic field generated by coil 114D of CMU 102 (for example, a position in proximity to coil 114D of CMU 102), and receives the second signal by detecting the magnetic field generated by coil 114D. The position information "Position2" is associated with magnetic sensor circuit 512D of the connected monitoring circuit.

Magnetic sensor circuit 513D is connected to Hall switch 523D. Hall switch 523D is positioned at a location where it can detect the magnetic field generated by coil 114D of CMU 103 (for example, a position in proximity to coil 114D of CMU 103), and receives the second signal by detecting the magnetic field generated by coil 114D. The position information "Position3" is associated with magnetic sensor circuit 513D of the connected monitoring circuit.

When any of magnetic sensor circuits 511D, 512D, and 513D receives the second signal, setting circuit 501D can obtain position information indicating the position of the monitoring circuit outputting the second signal by obtaining the position information associated with the communications interface that received the second signal (step S104 (see FIG. 10)). Setting circuit 501D generates and outputs correspondence information by associating the obtained position information and identification information (step S106).

In this way, setting circuit 501D can generate and output correspondence information using a communication line that includes elements that perform contactless communication using a magnetic field.

### Variation 5 of Embodiment

In the present variation, another example of the configuration of the battery management system will be given.

FIG. 16 is an explanatory diagram illustrating the configuration of BMS 1E, which is a battery management system according to the present variation. BMS 1E generates and outputs correspondence information using wired communication including contactless communication using sound waves.

Each of CMU 101 and the like according to present variation includes loudspeaker 114E. The other configurations are the same as CMU 101 and the like according to the embodiment.

Pairing circuit 133 included in CMU 101 and the like is connected to loudspeaker 114E. Pairing circuit 133 outputs the second signal by causing loudspeaker 114E to generate sound waves (in other words, sound) when it receives a signal (the first signal) from BMU 201 that includes identification information identical to its own identification information.

BMU 201 according to the present variation is the same as BMU 201 according to the embodiment.

Setting circuit 501D includes sound wave sensor circuits (Sound Sense.) 511E, 512E, and 513E.

Sound wave sensor circuit 511E is connected to microphone element 521E. Microphone element 521E is positioned at a location where it can detect sound waves generated by loudspeaker 114E of CMU 101 (for example, a position in proximity to loudspeaker 114E, specifically within approximately several centimeters from loudspeaker 114E), and receives the second signal by detecting the sound waves generated by loudspeaker 114E. The position information "Position1" is associated with sound wave sensor circuit 511E of the connected monitoring circuit. Sound wave sensor circuit 511E can also be said to be a communications interface that performs contactless communication with CMU 101 using sound waves, by means of elements (specific examples include loudspeaker 114E and microphone element 521E) that perform contactless communication using sound waves.

Sound wave sensor circuit 512E is connected to microphone element 522E. Microphone element 522E is positioned at a location where it can detect sound waves generated by loudspeaker 114E of CMU 102 (for example, a position in proximity to loudspeaker 114E of CMU 102), and receives the second signal by detecting the sound waves generated by loudspeaker 114E. The position information "Position2" is associated with sound wave sensor circuit 512E of the connected monitoring circuit.

Sound wave sensor circuit 513E is connected to microphone element 523E. Microphone element 523E is positioned at a location where it can detect the magnetic field generated by loudspeaker 114E of CMU 103 (for example, a position in proximity to loudspeaker 114E of CMU 103), and receives the second signal by detecting the sound waves generated by loudspeaker 114E. The position information "Position3" is associated with sound wave sensor circuit 513E of the connected monitoring circuit.

When any of sound wave sensor circuits 511E, 512E, and 513E receives the second signal, setting circuit 501E can obtain position information indicating the position of the monitoring circuit outputting the second signal (step S104 (see FIG. 10)). Setting circuit 501E generates and outputs correspondence information by associating the obtained position information and identification information (step S106).

In this way, setting circuit 501E can generate and output correspondence information using a communication line that includes elements that perform contactless communication using sound waves.

Embodiments arrived at by a person skilled in the art making various modifications to the embodiment, or embodiments realized by arbitrarily combining elements and functions in the embodiments which do not depart from the essence of the present disclosure are also included in the present disclosure.

### Additional Information

The following techniques are disclosed by the description of the above embodiment.

(Technique 1) A battery management system for managing a battery assembly includes: a management circuit that manages the battery assembly; a plurality of monitoring circuits that monitor the battery assembly; and a setting circuit. The management circuit wirelessly transmits, to the plurality of monitoring circuits, a first signal including identification information of one monitoring circuit among the plurality of monitoring circuits. Each monitoring circuit in the plurality of monitoring circuits includes identification information identifying the monitoring circuit, receives the first signal transmitted by the management circuit, and outputs a second signal on condition that the first signal received matches the identification information. The setting circuit generates and outputs correspondence information that associates (i) position information of the one monitoring circuit, among the plurality of monitoring circuits, that output the second signal with (ii) the identification information included in the first signal transmitted by the management circuit.

According to the above aspect, the battery management system can appropriately ascertain the position where the monitoring circuit is located using the correspondence information generated and output by the setting circuit. Here, the setting circuit can appropriately generate correspondence information using the second signal output by the monitoring circuit whose identification information matches the identification information included in the first signal transmitted via wireless communication by the management circuit. In this way, the battery management system can appropriately ascertain the position where the monitoring circuit is located.

(Technique 2) The battery management system according to Technique 1, wherein the one monitoring circuit outputs the second signal as light, and the setting circuit generates and outputs the correspondence information by obtaining an image showing the plurality of monitoring circuits including the one monitoring circuit outputting the light, and identifying the position information of the one monitoring circuit by performing image processing on the image obtained.

According to the above aspect, the setting circuit can easily identify the position of the monitoring circuit outputting light and generate correspondence information by performing image processing on an image showing a plurality of monitoring circuits. Accordingly, the battery management system can more easily and appropriately ascertain the position where the monitoring circuit is located using light output and image processing.

(Technique 3) The battery management system according to Technique 1, wherein the one monitoring circuit outputs the second signal as light, and the setting circuit accepts an input of the position information of the one monitoring circuit from a user, and generates and outputs the correspondence information by associating the position information input with the identification information.

According to the above aspect, the setting circuit can easily identify the position of the monitoring circuit outputting light and generate correspondence information using the position information input by the user. The position information input by the user may be, for example, position information indicating the position of the monitoring circuit outputting light, as determined by the user through visual observation. Accordingly, the battery management system can more easily and appropriately ascertain the position where the monitoring circuit is located using light output and user judgment.

(Technique 4) The battery management system according to Technique 1, wherein the setting circuit includes a plurality of communications interfaces connected one-to-one to the plurality of monitoring circuits via a communication line, each communication interface in the plurality of communications interfaces being associated with position information of the monitoring circuit connected to the communication interface, the one monitoring circuit outputs the second signal to the communication line connected to the setting circuit, and the setting circuit generates and outputs the correspondence information using the position information associated with one communications interface, among the plurality of communications interfaces, that received the second signal output.

According to the above aspect, the setting circuit can easily identify the position of the monitoring circuit outputting the second signal and generate correspondence information using the communications interface that received the second signal. Accordingly, the battery management system can more easily and appropriately ascertain the position where the monitoring circuit is located using a communication line (i.e., using wired communication).

(Technique 5) The battery management system according to Technique 4, wherein the communication line includes an element that performs contactless communication using light.

According to the above aspect, the setting circuit can easily identify the position of the monitoring circuit outputting the second signal and generate correspondence information by performing wired communication in an insulated state with the monitoring circuit using contactless communication with light. Since the setting circuit is insulated from the monitoring circuit, the setting circuit can maintain stable or safe operation by inhibiting the effects of current or voltage that may be generated by the monitoring circuit and could potentially interfere with the stable or safe operation of the setting circuit. Accordingly, the battery management system can appropriately ascertain the position where the monitoring circuit is located while operating more stably or safely.

(Technique 6) The battery management system according to Technique 4, wherein the communication line includes an element that performs contactless communication using a magnetic field.

According to the above aspect, the setting circuit can easily identify the position of the monitoring circuit outputting the second signal and generate correspondence information by performing wired communication in an insulated state with the monitoring circuit using contactless communication with a magnetic field. Since the setting circuit is insulated from the monitoring circuit, the setting circuit can maintain stable or safe operation by inhibiting the effects of current or voltage that may be generated by the monitoring circuit and could potentially interfere with the stable or safe operation of the setting circuit. Accordingly, the battery management system can appropriately ascertain the position where the monitoring circuit is located while operating more stably or safely.

(Technique 7) The battery management system according to Technique 4, wherein the communication line includes an element that performs contactless communication using a sound wave.

According to the above aspect, the setting circuit can easily identify the position of the monitoring circuit outputting the second signal by performing wired communication in an insulated state with the monitoring circuit using contactless communication with sound waves. By being insulated from the monitoring circuit, the setting circuit can maintain stable or safe operation by inhibiting the effects of current or voltage that may be generated by the monitoring circuit. Accordingly, the battery management system can appropriately ascertain the position where the monitoring circuit is located while operating more stably or safely.

(Technique 8) The battery management system according to any one of Techniques 1 to 7, wherein the management circuit obtains the correspondence information for the plurality of monitoring circuits, and uses the correspondence information obtained to perform communication, for managing the battery assembly, with the plurality of monitoring circuits.

According to the above aspect, the battery management system can more appropriately manage the battery assembly by using the generated and output correspondence information to identify a monitoring circuit having specific identification information from among the plurality of monitoring circuits. In this way, the battery management system can manage the battery assembly while appropriately ascertaining the position where the monitoring circuit is located.

(Technique 9) The battery management system according to any one of Techniques 1 to 8, wherein the plurality of monitoring circuits include a cell monitoring circuit that monitors one or more battery cells included in the battery assembly or a current monitoring circuit that measures current flowing in the battery assembly.

According to the above aspect, the battery management system can more easily and appropriately ascertain the position where the cell monitoring circuit or current monitoring circuit is located.

### [Industrial Applicability]

The present disclosure is applicable to a battery management system or the like in which wireless communication is performed within the system.

### [Reference Signs List]

1, 1A, 1B, 1C, 1D, 1E BMS
10 battery pack
11 battery cell
20 junction box
100 monitoring circuit
101, 102, 103 CMU (Cell Monitoring Unit)
111, 211, 312 wireless communication circuit
112 voltage monitoring circuit
113, 114, 114C, 313 LED
114B, 123, 145, 223, 323, 333, 511, 511B, 512B, 513B communications interface
114D coil
114E loudspeaker
121, 141, 221, 331 voltage conversion circuit
122, 142, 222, 332 timer circuit
124, 224, 334 clock generation circuit
125, 146, 225, 324, 335 phase-locked loop
126, 226, 337 modulation circuit
127, 227, 338 transmission circuit
128, 228, 339 demodulation circuit
129, 229, 340 reception circuit
131, 231, 341 communication error determination circuit
132, 232, 342 wake-up circuit
133 pairing circuit
143 multiplexer
144, 322 AD converter
147, 241, 325, 336 encryption circuit
148 switch
200 management circuit
201 BMU
212 MCU
213, 519 CAN interface
230 non-volatile memory
242 identification circuit
243 table
301 CMU (Current Monitoring Unit)
321 amplification circuit
311 current measurement circuit
400 motor
401 relay
402 shunt resistor
405 power line
501, 501A, 501B, 501C, 501D, 501E setting circuit
511A input terminal
511C, 512C, 513C photosensor circuit
511D, 512D, 513D magnetic sensor circuit
511E, 512E, 513E sound wave sensor circuit
521C, 522C, 523C photosensor element
521D, 522D, 523D Hall switch
521E, 522E, 523E microphone element
ANT1, ANT2, ANT3 communication antenna

## Claims

1. A battery management system for managing a battery assembly, the battery management system comprising:
a management circuit that manages the battery assembly;
a plurality of monitoring circuits that monitor the battery assembly; and
a setting circuit, wherein
the management circuit wirelessly transmits, to the plurality of monitoring circuits, a first signal including identification information of one monitoring circuit among the plurality of monitoring circuits,
each monitoring circuit in the plurality of monitoring circuits includes identification information identifying the monitoring circuit, receives the first signal transmitted by the management circuit, and outputs a second signal on condition that the first signal received matches the identification information, and
the setting circuit generates and outputs correspondence information that associates (i) position information of the one monitoring circuit, among the plurality of monitoring circuits, that output the second signal with (ii) the identification information included in the first signal transmitted by the management circuit.

2. The battery management system according to claim 1, wherein
the one monitoring circuit outputs the second signal as light, and
the setting circuit generates and outputs the correspondence information by obtaining an image showing the plurality of monitoring circuits including the one monitoring circuit outputting the light, and identifying the position information of the one monitoring circuit by performing image processing on the image obtained.

3. The battery management system according to claim 1, wherein
the one monitoring circuit outputs the second signal as light, and
the setting circuit accepts an input of the position information of the one monitoring circuit from a user, and generates and outputs the correspondence information by associating the position information input with the identification information.

4. The battery management system according to claim 1, wherein
the setting circuit includes a plurality of communications interfaces connected one-to-one to the plurality of monitoring circuits via a communication line, each communication interface in the plurality of communications interfaces being associated with position information of the monitoring circuit connected to the communication interface,
the one monitoring circuit outputs the second signal to the communication line connected to the setting circuit, and
the setting circuit generates and outputs the correspondence information using the position information associated with one communications interface, among the plurality of communications interfaces, that received the second signal output.

5. The battery management system according to claim 4, wherein
the communication line includes an element that performs contactless communication using light.

6. The battery management system according to claim 4, wherein
the communication line includes an element that performs contactless communication using a magnetic field.

7. The battery management system according to claim 4, wherein
the communication line includes an element that performs contactless communication using a sound wave.

8. The battery management system according to any one of claims 1 to 7, wherein
the management circuit obtains the correspondence information for the plurality of monitoring circuits, and uses the correspondence information obtained to perform communication, for managing the battery assembly, with the plurality of monitoring circuits.

9. The battery management system according to any one of claims 1 to 8, wherein
the plurality of monitoring circuits include a cell monitoring circuit that monitors one or more battery cells included in the battery assembly or a current monitoring circuit that measures current flowing in the battery assembly.
